# EUROPÄISCHE PATENTSCHRIFT

(11) **EP 2 557 676 B1**
(45) Veröffentlichungstag und Bekanntmachung des Hinweises auf die Patenterteilung: **26.02.2014**
(21) Anmeldenummer: 11176933.7
(22) Anmeldetag: 09.08.2011
(51) Int. Cl.: H02M 7/00

(54) **Umrichteranordnung mit einem Luftkühlsystem**
Converter device with an air cooling system
Agencement de convertisseur doté d'un système de refroidissement de l'air

(43) Veröffentlichungstag der Anmeldung: 13.02.2013
(73) Patentinhaber: Siemens Aktiengesellschaft, 80333 München (DE)
(72) Erfinder: Lottes, Wolfgang, 90489 Nürnberg (DE); Hoffmann, Ingolf, 91074 Herzogenaurach (DE)

(56) Entgegenhaltungen:
- EP-A2- 0 356 991
- WO-A1-2008/071192
- DE-A1- 10 153 748

## Beschreibung

Die Erfindung betrifft eine Umrichteranordnung mit einem Luftkühlsystem.

Die Umrichteranordnung weist ein Gehäuse, mindestens einen im Gehäuse angeordneten Kondensator, einen Lüfter und eine im Gehäuse angeordnete erste leistungselektronische Baugruppe auf.

Luftgekühlte Umrichter sind allgemein bekannt und weisen in verbreiteter Ausprägung einen Wechselrichter, einen Zwischenkreiskondensator sowie einen Gleichrichter auf. Eine Verschienung stellt eine elektrische Verbindung der drei Umrichterelemente her.

Aus der DE 101 53 748 A1 ist eine durch eine Lüftereinheit gekühlte Stromrichtereinheit mit einer Zwischenkreis-Kondensatorbatterie und einem Leistungsmodul bekannt. Bleche vervollständigen einen Montagerahmen zu einem Kühlkanal, und die Kondensatorbatterie und das Leistungsmodul sind einander gegenüberliegend jeweils auf einer Seite einer doppelseitig bestückbaren Kühleinrichtung angeordnet.

Aus der WO2008/071192 A1 und der EP 0 356 991 A2 sind auch Umrichteranordnungen mit einer Zwischenkreis-Kondensatorbatterie und einem Leistungsmodul bekannt, die mit einer Lüftereinheit gekühlt sind. Die Luftstrom ist in zwei Teile ohne thermische Trennung unterteilt.

Der Erfindung liegt die Aufgabe zugrunde, eine Umrichteranordnung mit verbesserter Kühlung zu schaffen.

Diese Aufgabe wird durch eine Umrichteranordnung gemäß Anspruch 1 gelöst, indem die Umrichteranordnung ein Gehäuse, mindestens einen im Gehäuse angeordneten Kondensator, einen Lüfter zum Erzeugen eines Kühlluftstroms und eine im Gehäuse angeordnete erste leistungselektronische Baugruppe aufweist, wobei die erste leistungselektronische Baugruppe in Richtung des Kühlluftstroms betrachtet zwischen dem mindestens einen Kondensator und dem Lüfter angeordnet ist, die erste leistungselektronische Baugruppe derart in Bezug auf den Lüfter positioniert ist, dass sie lediglich von einem ersten Teilluftstrom des Kühlluftstroms gekühlt wird und wobei ein zur Kühlung des mindestens einen Kondensators vorgesehener zweiter Teilluftstrom des Kühlluftstroms durch einen im Gehäuse angeordneten ersten Kanal derart an der ersten leistungselektronischen Baugruppe vorbeigeleitet wird, dass der erste Teilluftstrom von der ersten leistungselektronischen Baugruppe thermisch getrennt ist.

Der Begriff leistungselektronische Baugruppe umfasst in diesem Zusammenhang sowie im gesamten Dokument sowohl leistungselektronische Halbleiter-Bauelemente, insbesondere Leistungshalbleiter oder Halbleiterschalter, als auch einen etwaigen zu deren Kühlung vorgesehenen Kühlkörper.

Die Aufteilung des Kühlluftstromes in einen ersten Teilluftstrom und einen zweiten Teilluftstrom erlaubt die Kühlung der leistungselektronischen Baugruppe über den ersten, noch kalten Teilluftstrom des Kühlluftstromes.

Der zweite Teilluftstrom des Kühlluftstroms versorgt den mindestens einen Kondensator dadurch mit noch kalter Kühlluft, dass der zweite Teilluftstrom mittels des ersten Kanals von der ersten leistungselektronischen Baugruppe thermisch getrennt ist und damit noch nicht erwärmt wurde.

Folglich werden sowohl die erste leistungselektronische Baugruppe als auch der mindestens eine Kondensator durch noch kalte Kühlluft gekühlt, obwohl der mindestens eine Kondensator in Richtung des Kühlluftstroms betrachtet hinter der ersten leistungselektronischen Baugruppe angeordnet ist.

Da durch leistungselektronische Baugruppen Verlustwärme erzeugt wird, jedoch eine zu hohe Temperatur die Lebensdauer von Kondensatoren verkürzt, weist die erfindungsgemäße Umrichteranordnung Vorteile gegenüber Umrichteranordnungen des Standes der Technik insbesondere bezüglich der Lebensdauer und der maximalen Umgebungstemperatur auf. Zusätzlich ergibt sich als Vorteil eine höhere Strombelastbarkeit.

Weitere vorteilhafte Ausgestaltungen der erfindungsgemäßen Umrichteranordnung sind den abhängigen Ansprüchen 2 bis 11 zu entnehmen.

Bei einer vorteilhaften Ausgestaltung der Erfindung leitet ein im Gehäuse angeordneter zweiter Kanal den zur Kühlung der ersten leistungselektronischen Baugruppe vorgesehenen ersten Teilluftstrom derart an dem mindestens einen Kondensator vorbei, dass er von dem mindestens einen Kondensator thermisch getrennt ist.

Der erste Teilluftstrom wird durch die erste leistungselektronische Baugruppe erwärmt und in Richtung des Kühlluftstroms betrachtet hinter der ersten leistungselektronischen Baugruppe derart an dem mindestens einen Kondensator vorbeigeleitet, dass der mindestens eine Kondensator mit noch kalter Kühlluft versorgt wird.

Eine vorteilhafte Ausgestaltung der Erfindung weist zusätzlich eine zweite leistungselektronische Baugruppe auf, welche in Richtung des Kühlluftstroms hinter dem mindestens einen Kondensator angeordnet ist.

Diese Ausgestaltung weist weiterhin Mittel zum Zusammenführen der beiden Teilluftströme auf, wobei die beiden zusammengeführten Teilluftströme zur Kühlung der zweiten leistungselektronischen Baugruppe vorgesehen sind.

Die Mittel können innerhalb des Gehäuses der Gestalt sein, dass die beiden Kanäle in Richtung des Kühlluftstroms betrachtet hinter dem mindestens einen Kondensator vereinigt werden. Die Mittel können dadurch realisiert sein, dass die beiden Teilluftströme aus den Kanälen heraus fließen und in einen gemeinsamen Kanal hinein fließen, welcher sich in Richtung des Kühlluftstroms verjüngen kann. Die Mittel können insbesondere in Form eines Bleches zum Leiten der Teilluftströme ausgeführt sein.

Gemäß dieser Ausgestaltung sind in Richtung des Kühlluftstroms zunächst der Lüfter, anschließend die erste leistungselektronische Baugruppe, dann der mindestens eine Kondensator und schließlich die zweite leistungselektronische Baugruppe angeordnet. Dies erlaubt eine direkte, lineare elektrische Verschienung als Verbindung der drei zuvor genannten elektrischen Einheiten in Richtung des elektrischen Stromflusses und vermeidet eine Schleifenbildung der elektrischen Verschienung. Die direkte, lineare elektrische Verschienung bedeutet einen reduzierten Verschienungsaufwand und bietet als besonderen Vorteil, dass Material eingespart werden kann. Aufgrund der relativ hohen Kosten insbesondere für eine Kupfer-Verschienung ergeben sich dank des reduzierten Verschienungsaufwands erhebliche Kosteneinsparungen. Weiterhin ist von Vorteil, dass der mindestens eine Kondensator wie auch die erste leistungselektronische Baugruppe mit noch frischer Kühlluft gekühlt werden.

Die Umrichteranordnung kann gemäß einer vorteilhaften Ausgestaltung ein Spannungszwischenkreisumrichter sein, der dank der verbesserten Kühlung bei erhöhter Umgebungstemperatur betreibbar ist.

Gemäß einer weiteren vorteilhaften Ausgestaltung können die erste leistungselektronische Baugruppe ein Wechselrichter und der mindestens eine Kondensator ein Spannungszwischenkreiskondensator sein. Insbesondere werden für den Wechselrichter Halbleiter-Bauelemente, insbesondere Leistungshalbleiter oder Halbleiterschalter, wie beispielsweise IGBT oder andere Transistoren, sowie Freilaufdioden verwendet. Die Kondensatoren können beispielsweise als Elektrolytkondensatoren, Doppelschichtkondensatoren oder dergleichen ausgeführt sein.

In vorteilhafter Ausgestaltung der Erfindung ist die zweite leistungselektronische Baugruppe als Gleichrichter ausgeführt. Insbesondere kann der Gleichrichter als Brückengleichrichter mit Dioden ausgeführt sein. Besonders vorteilhaft ist dabei, dass Brückengleichrichter mit Dioden im Vergleich zu Wechselrichtern mit Leistungshalbleitern weniger Verlustwärme produzieren und somit weniger Kühlleistung benötigen. Daher kann zur Kühlung des Gleichrichters die durch die in Richtung des Kühlluftstroms vorher angeordneten elektrischen Einheiten schon vorgewärmte Kühlluft verwendet werden. Denkbar ist auch, einen mit Halbleiter-Bauelementen, insbesondere Leistungshalbleitern oder Halbleiterschaltern, wie beispielsweise IGBT oder anderen Transistoren sowie Freilaufdioden ausgerüsteten Gleichrichter zu verwenden, der einen Vier-Quadranten-Betrieb erlaubt.

Zusätzlich kann die Umrichteranordnung gemäß einer weiteren vorteilhaften Ausführung eine Bremseinheit aufweisen. Diese umfasst einen Brems-Chopper und mindestens einen Bremswiderstand. Beispielsweise kann der mindestens eine Bremswiderstand in Richtung des Kühlluftstroms betrachtet hinter dem mindestens einen Kondensator angeordnet sein. Möglich ist dabei, dass der mindestens eine Bremswiderstand durch lediglich einen der Teilluftströme gekühlt wird, durch die beiden Teilluftströme zusammen oder durch einen dritten Teilluftstrom, der parallel zum zweiten geführt wird.

Bei einer vorteilhaften Ausgestaltung der Erfindung umfasst die erste leistungselektronische Baugruppe Halbleiter-Bauelemente und einen zu deren Kühlung vorgesehenen Kühlkörper.

Halbleiter-Bauelemente sind für die Leistungselektronik besonders gut geeignet, wobei der Abtransport der in den Halbleiter-Bauelementen entstehenden Verlustwärme durch den Kühlkörper verbessert wird.

Gemäß einer weiteren vorteilhaften Ausgestaltung der Erfindung ist der Kühlkörper derart in Bezug auf den Kühlluftstrom angeordnet, dass er von dem ersten Teilluftstrom durchströmt wird. Dabei wird der zweite Teilluftstrom durch den ersten Kanal derart an dem Kühlkörper vorbeigeleitet, dass der zweite Teilluftstrom von dem Kühlkörper thermisch getrennt ist.

Diese Anordnung erlaubt eine gute Kühlung der ersten leistungselektronischen Baugruppe durch den Kühlkörper und gleichzeitig die Versorgung des mindestens einen Kondensators mit frischer Kühlluft durch den zweiten Teilluftstrom, der von der ersten leistungselektronischen Baugruppe thermisch getrennt ist.

Bei einer vorteilhaften Ausgestaltung der Erfindung umfasst das Gehäuse mindestens ein Gehäuseteil, welches mindestens eine Einflussöffnung zum Einleiten des zweiten Teilluftstroms und eine Ausflussöffnung zum Ausleiten des zweiten Teilluftstroms aufweist und welches den mindestens einen Kondensator unter Bildung eines Kühlluftspaltes zwischen dem mindestens einen Kondensator und dem Gehäuseteil zumindest teilweise umschließt.

Der zweite Teilluftstrom dringt durch die Einflussöffnung in das Gehäuseteil ein, wird durch das Gehäuseteil am mindestens einen Kondensator zwecks Kühlung im Kühlluftspalt entlang geleitet und verlässt das Gehäuseteil schließlich durch die Ausflussöffnung. Das Gehäuseteil erlaubt somit eine gute Kühlung des mindestens einen Kondensators und gleichzeitig eine thermische Trennung des zweiten Teilluftstroms vom ersten Teilluftstrom.

Gemäß einer weiteren vorteilhaften Ausgestaltung der Erfindung wird der mindestens eine Kondensator zusammen mit mehreren Kondensatoren in Richtung des Kühlluftstroms in Zeilen angeordnet. Dabei umschließt das Gehäuseteil jeweils eine Zeile derart zumindest teilweise, dass zwischen den Zeilen der zweite Kanal gebildet wird, durch welchen der erste Teilluftstrom an den Kondensatoren vorbeigeleitet wird.

Durch die Anordnung der Kondensatoren in Zeilen entlang des Kühlluftstroms ergeben sich für den zweiten Kanal vorteilhafte Strömungseigenschaften, wobei gleichzeitig die Kühlung der Kondensatoren durch den zweiten Teilluftstrom gewährleistet ist.

Der erste Kanal, durch welchen der zweite Teilluftstrom fließt, kann insbesondere durch das Gehäuse der Umrichteranordnung und ein Gehäuseelement, welches den Kühlkörper der ersten leistungselektronischen Baugruppe begrenzt, gebildet werden. Beispielsweise kann das Gehäuseelement den vom Lüftern kommenden Kühlluftstrom aufteilen in zumindest den ersten Teilluftstrom und den zweiten Teilluftstrom.

Im Folgenden wird die Erfindung anhand der in den Figuren dargestellten Ausführungsbeispiele näher beschrieben und erläutert. Es zeigen:
- FIG 1: eine Prinzipdarstellung der erfindungsgemäßen Umrichteranordnung,
- FIG 2: eine erste Ausführungsform der erfindungsgemäßen Umrichteranordnung,
- FIG 3: ein elektrisches Schaltbild einer weiteren Ausführungsform der erfindungsgemäßen Umrichteranordnung,
- FIG 4: einen Ausschnitt der ersten Ausführungsform der erfindungsgemäßen Umrichteranordnung und
- FIG 5: einen weiteren Ausschnitt der ersten Ausführungsform der erfindungsgemäßen Umrichteranordnung

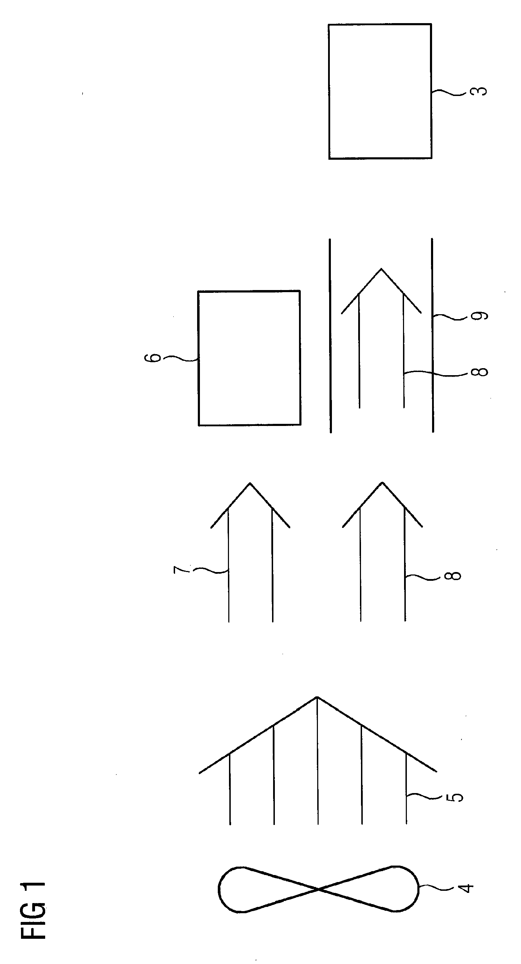

FIG 1 zeigt eine Prinzipdarstellung der erfindungsgemäßen Umrichteranordnung mit einer ersten leistungselektronischen Baugruppe 6 und einem Kondensator 3. Ein Lüfter 4 erzeugt einen Kühlluftstrom 5, wobei in Richtung des Kühlluftstroms 5 der Kondensator 3 hinter der ersten leistungselektronischen Baugruppe 6 angeordnet ist.

Die erste leistungselektronische Baugruppe 6 ist so positioniert, dass sie lediglich von einem ersten Teilluftstrom 7 des Kühlluftstroms 5 gekühlt wird. Ein zweiter Teilluftstrom 8 des Kühlluftstroms 5 kühlt den Kondensator 3. Ein erster Kanal 9 führt dabei den zweiten Teilluftstrom 8 derart an der ersten leistungselektronischen Baugruppe 6 vorbei, dass der zweite Teilluftstrom von der ersten leistungselektronischen Baugruppe thermisch getrennt ist.

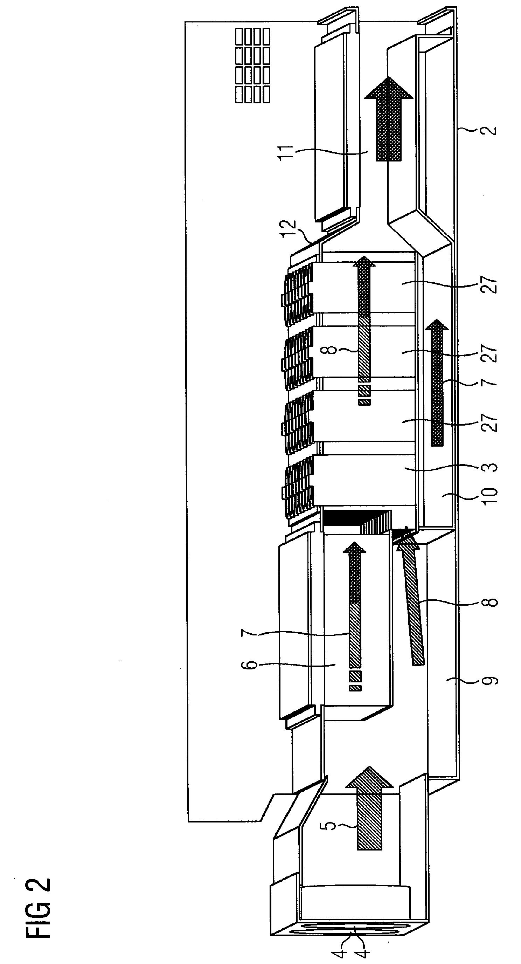

In FIG 2 wird eine erste Ausführungsform der erfindungsgemäßen Umrichteranordnung gezeigt, wobei zwei nebeneinander angeordnete Lüfter 4 einen Kühlluftstrom 5 erzeugen. In Richtung des Kühlluftstroms 5 sind innerhalb eines Gehäuses 2 zunächst eine erste leistungselektronische Baugruppe 6, dann ein Kondensator 3 und weitere Kondensatoren 27 und schließlich eine zweite leistungselektronische Baugruppe 11 angeordnet. Die erste leistungselektronische Baugruppe 6 umfasst einen in der Figur erkennbaren Kühlkörper und nicht dargestellte Halbleiter-Bauelemente.

Der Kühlluftstrom 5 wird in einen ersten Teilluftstrom 7 und einen zweiten Teilluftstrom 8 unterteilt, wobei der erste Teilluftstrom 7 die erste leistungselektronische Baugruppe 6 kühlt und der zweite Teilluftstrom 8 den Kondensator 3 und die weiteren Kondensatoren 27 kühlt.

Der zweite Teilluftstrom 8 wird zunächst in einem Bypass durch einen ersten Kanal 9 an der ersten leistungselektronischen Baugruppe 6 vorbeigeleitet und nimmt aufgrund der durch den Bypass bewirkten Trennung dabei keine von der ersten leitungselektronischen Baugruppe 6 erzeugte Wärme auf. Anschließend kühlt der zweite Teilluftstrom 8 den Kondensator 3 und die weiteren Kondensatoren 27 und erwärmt sich dabei.

Der erste Teilluftstrom 7 kühlt zunächst die erste leistungselektronische Baugruppe 6 und erwärmt sich hierdurch. Danach wird er in einem weiteren Bypass in Form eines zweiten Kanals 10 am Kondensator 3 und den weiteren Kondensatoren 27 vorbeigeleitet, wobei der Kondensator 3 und die weiteren Kondensatoren 27 durch die thermische Trennung vom ersten Teilluftstrom 7 nicht durch diesen erwärmt werden.

Mittel 12 zum Zusammenführen der beiden Teilluftströme 7 und 8 sind bei dieser Ausführungsform derart ausgeführt, dass der erste Teilluftstrom 7 im zweiten Kanal 10 so weit in Richtung des Kühlluftstroms 5 geführt wird, bis der zweite Kanal endet und der erste Teilluftstrom 7 mit dem zweiten Teilluftstrom 8, der den Kondensator 3 und die weiteren Kondensatoren 27 gekühlt hat, vereinigt wird. Dabei umfassen die Mittel 12 zum Zusammenführen der beiden Teilluftströme 7 und 8 eine Verjüngung des Kanals, in welchem sich die beiden zusammengeführten Teilluftströme 7 und 8 bewegen. Die beiden zusammengeführten Teilluftströme 7 und 8 kühlen schließlich die zweite leistungselektronische Baugruppe 11.

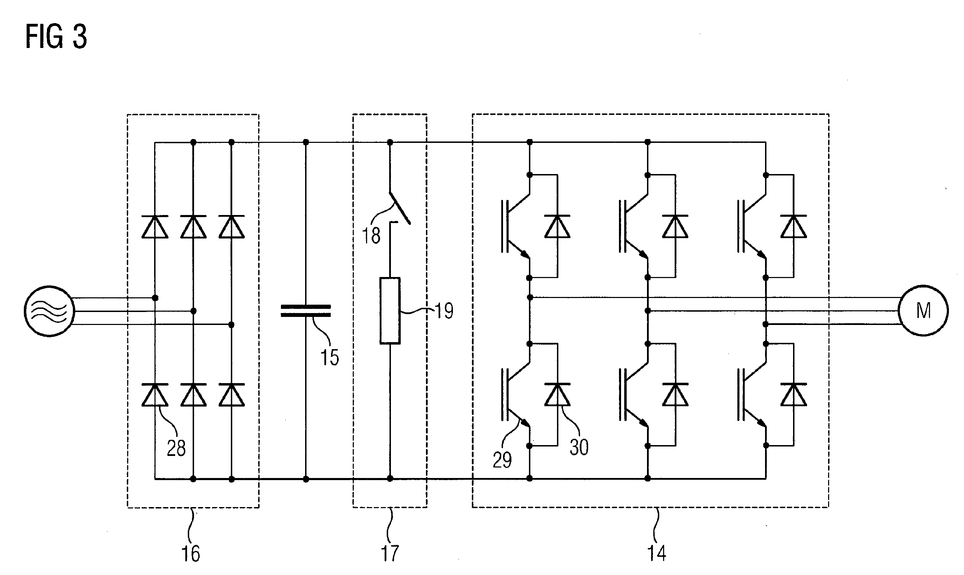

In FIG 3 ist ein elektrisches Schaltbild einer weiteren Ausführungsform der erfindungsgemäßen Umrichteranordnung dargestellt, die als Spannungszwischenkreisumrichter ausgeführt ist. Ein netzseitiger dreiphasiger Drehstrom wird zunächst durch Gleichrichterdioden 28 eines Gleichrichters 16 gleichgerichtet und versorgt einen Spannungszwischenkreiskondensator 15. Die Zwischenkreisspannung wird in einem Wechselrichter 14 mit Hilfe von Transistoren 29 und Freilaufdioden 30 in eine dreiphasige Wechselspannung, beispielsweise zur Versorgung eines Verbrauchers M, umgewandelt.

Diese Anordnung weist eine Bremseinheit 17 auf, welche sich zwischen Spannungszwischenkreiskondensator 15 und Wechselrichter 14 befindet. Die Bremseinheit 17 verbindet die beiden Pole des Spannungszwischenkreiskondensators 15 über einen Brems-Chopper 18 und einen Bremswiderstand 19.

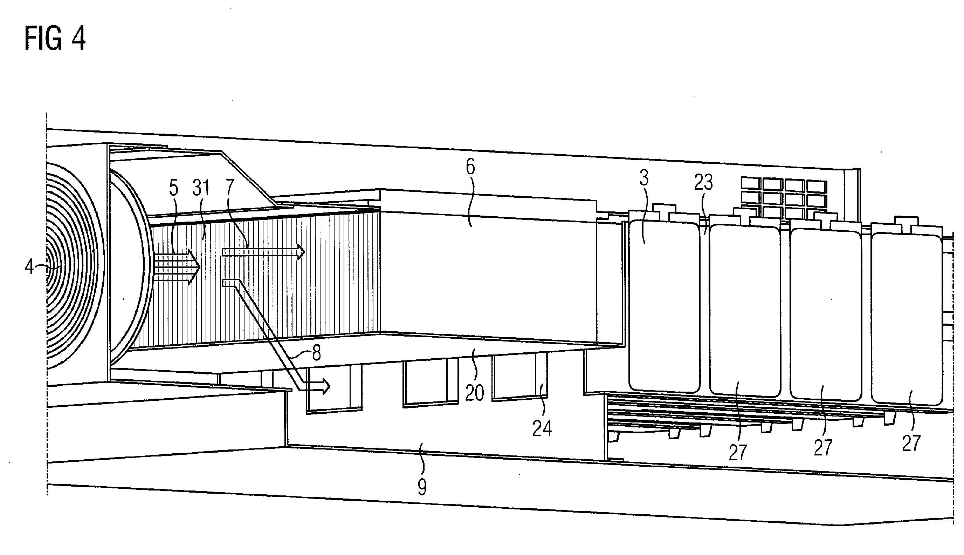

FIG 4 zeigt einen Ausschnitt der ersten Ausführungsform der erfindungsgemäßen Umrichteranordnung. Ein Kühlkörper 31 ist zur Kühlung der ersten leistungselektronischen Baugruppe 6 vorgesehen und wird nach unten durch ein Gehäuseelement 20 begrenzt, welches den von den Lüftern 4 kommenden Kühlluftstrom 5 zweiteilt in den ersten Teilluftstrom 7 und den zweiten Teilluftstrom 8. Der erste Teilluftstrom 7 strömt oberhalb des Gehäuseelementes 20 durch den Kühlkörper und transportiert die in der ersten leistungselektronischen Baugruppe 6 entstehende Verlustwärme ab.

Der zweite Teilluftstrom 8 fließt unterhalb des Gehäuseelements 20 im ersten Kanal 9 an der ersten leistungselektronischen Baugruppe 6 vorbei. Dabei wird der zweite Teilluftstrom 8 durch das Gehäuseelement 20 von der ersten leistungselektronischen Baugruppe 6 thermisch getrennt und fließt über eine Einflussöffnung 24 zum Einleiten des zweiten Teilluftstroms 8 in ein Gehäuseteil 23 ein, welches den Kondensator 3 und die weiteren Kondensatoren 27 zumindest teilweise umgibt.

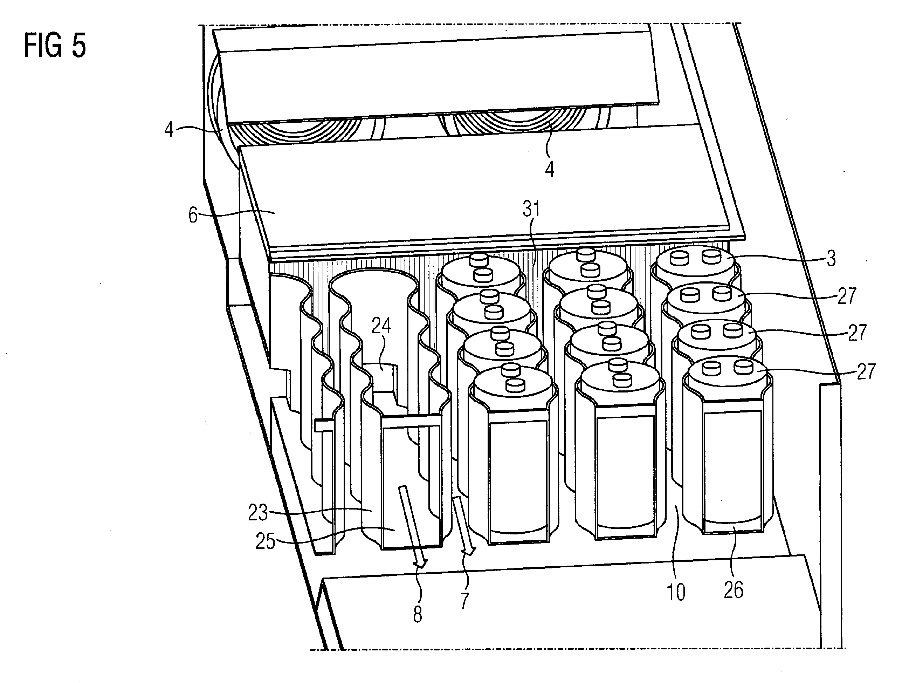

In FIG 5 ist ein weiterer Ausschnitt der ersten Ausführungsform der erfindungsgemäßen Umrichteranordnung gezeigt.

Der zweite Teilluftstrom 8 dringt durch die Einflussöffnung 24 zum Einleiten des zweiten Teilluftstroms 8 in das Gehäuseteil 23 ein und verlässt dieses durch eine Ausflussöffnung 25 zum Ausleiten des zweiten Teilluftstroms 8. Der Kondensator 3 und die weiteren Kondensatoren 27 sind in Zeilen entlang der Richtung der Teilluftströme 7, 8 angeordnet, wobei die Zeilen den gleichen Aufbau haben. Lediglich um eine verständlichere Darstellung in der Figur 5 zu ermöglichen, sind in einer der Zeilen die Kondensatoren 3, 27 ausgeblendet. Der Kondensator 3 und die weiteren Kondensatoren 27 werden teilweise vom Gehäuseteil 23 umgeben, wobei ein Kühlluftspalt 26 bestehen bleibt, durch welchen der zweite Teilluftstrom 8 fließt. Der Kühlluftspalt 26 kann konisch ausgeführt sein, um die Umspulung der zylinderförmigen Kondensatoren 3, 27 mit Frischluft, die aus der Einflussöffnung 24 zum Einleiten des zweiten Teilluftstroms 8 kommt, zu verbessern.

Der erste Teilluftstrom 7 strömt durch den Kühlkörper 31 der ersten leistungselektronischen Baugruppe 6. Anschließend wird der erste Teilluftstrom 7 im zweiten Kanal 10 entlang des Gehäuseteils 23 geleitet, wobei der zweite Kanal 10 begrenzt wird durch das Gehäuseteil 23 zweier benachbarter Zeilen, in welchen die Kondensatoren 3, 27 angeordnet sind. Dabei ist der erste Teilluftstrom 7 vom Kondensator 3 und den weiteren Kondensatoren 27 thermisch getrennt.

## Patentansprüche

1. Umrichteranordnung mit
- einem Gehäuse (2),
- mindestens einem im Gehäuse (2) angeordneten Kondensator (3),
- einem Lüfter (4) zum Erzeugen eines Kühlluftstroms (5) und
- einer im Gehäuse (2) angeordneten ersten leistungselektronischen Baugruppe (6),
- wobei die erste leistungselektronische Baugruppe (6) in Richtung des Kühlluftstroms (5) betrachtet zwischen dem mindestens einen Kondensator (3) und dem Lüfter (4) angeordnet ist,
- die erste leistungselektronische Baugruppe (6) derart in Bezug auf den Lüfter (4) positioniert ist, dass sie lediglich von einem ersten Teilluftstrom (7) gekühlt wird und
- wobei ein zur Kühlung des mindestens einen Kondensators (3) vorgesehener zweiter Teilluftstrom (8) durch einen im Gehäuse (2) angeordneten ersten Kanal (9) derart an der ersten leistungselektronischen Baugruppe (6) vorbeigeleitet wird, dass der zweite Teilluftstrom (8) von der ersten leistungselektronischen Baugruppe (6) thermisch getrennt ist.

2. Umrichteranordnung nach Anspruch 1, wobei der zur Kühlung der ersten leistungselektronischen Baugruppe (6) vorgesehene erste Teilluftstrom (7) durch einen im Gehäuse (2) angeordneten zweiten Kanal (10) derart an dem mindestens einen Kondensator (3) vorbeigeleitet wird, dass der erste Teilluftstrom (7) von dem mindestens einen Kondensator (3) thermisch getrennt ist.

3. Umrichteranordnung nach Anspruch 1 oder 2 mit
- einer zweiten leistungselektronischen Baugruppe (11), welche in Richtung des Kühlluftstroms (5) hinter dem mindestens einen Kondensator (3) angeordnet ist und
- Mitteln zum Zusammenführen (12) der beiden Teilluftströme (7,8), wobei die beiden zusammengeführten Teilluftströme (7,8) zur Kühlung der zweiten leistungselektronischen Baugruppe (11) vorgesehen sind.

4. Umrichteranordnung nach einem der vorhergehenden Ansprüche, wobei die Umrichteranordnung ein Spannungszwischenkreisumrichter (13) ist.

5. Umrichteranordnung nach einem der vorhergehenden Ansprüche, wobei die erste leistungselektronische Baugruppe (6) ein Wechselrichter (14) und der mindestens eine Kondensator (3) ein Spannungszwischenkreiskondensator (15) ist.

6. Umrichteranordnung nach Anspruch 3, wobei die zweite leistungselektronische Baugruppe (11) ein Gleichrichter (16) ist.

7. Umrichteranordnung nach einem der vorhergehenden Ansprüche mit
- einer Bremseinheit (17), die einen Brems-Chopper (18) und mindestens einen Bremswiderstand (19) umfasst,
- wobei der mindestens eine Bremswiderstand (19) durch mindestens einen Teilluftstrom (7, 8) gekühlt wird.

8. Umrichteranordnung nach einem der vorhergehenden Ansprüche, wobei die erste leistungselektronische Baugruppe (6) Halbleiter-Bauelemente und einen zu deren Kühlung vorgesehenen Kühlkörper (31) umfasst.

9. Umrichteranordnung nach Anspruch 8, wobei der Kühlkörper (31) derart in Bezug auf den Kühlluftstrom (5) angeordnet ist, dass er von dem ersten Teilluftstrom (7) durchströmt wird und der zweite Teilluftstrom (8) durch den ersten Kanal (9) derart an dem Kühlkörper (31) vorbeigeleitet wird, dass der zweite Teilluftstrom (8) von dem Kühlkörper (31) thermisch getrennt ist.

10. Umrichteranordnung nach einem der vorhergehenden Ansprüche, wobei das Gehäuse (2) mindestens ein Gehäuseteil (23) umfasst, welches mindestens eine Einflussöffnung (24) zum Einleiten des zweiten Teilluftstroms (8) und eine Ausflussöffnung (25) zum Ausleiten des zweiten Teilluftstroms (8) aufweist und welches den mindestens einen Kondensator (3) unter Bildung eines Kühlluftspaltes (26) zwischen dem mindestens einen Kondensator (3) und dem Gehäuseteil (23) zumindest teilweise umschließt.

11. Umrichteranordnung nach Anspruch 10, wobei der mindestens eine Kondensator (3) zusammen mit mehreren Kondensatoren (27) in Richtung des Kühlluftstroms (5) in Zeilen angeordnet ist, wobei das Gehäuseteil (23) jeweils eine Zeile derart zumindest teilweise umschließt, dass zwischen den Zeilen der zweite Kanal (10) gebildet wird, durch welchen der erste Teilluftstrom (7) an den Kondensatoren (3,27) vorbeigeleitet wird.

## Claims

1. Converter arrangement with
- a housing (2),
- at least one capacitor (3) disposed in the housing (2),
- a fan (4) for generating a cooling air flow (5) and
- a first power electronics module (6) disposed in the housing (2),
- wherein the first power electronics module (6), viewed in the direction of the cooling air flow (5), is disposed between the at least one capacitor (3) and the fan (4),
- the first power electronics module (6) is positioned in relation to the fan (4) such that it is only cooled by a first part air flow (7) and
- wherein a second part air flow (8) provided for cooling the at least one capacitor (3) is routed via a first channel (9) disposed in the housing (2) past the first power electronics module (6) such that the second part air flow (8) is thermally separated from the first power electronics module (6).

2. Converter arrangement according to claim 1, wherein the first part air flow (7) provided for cooling the first power electronics module (6) is routed via a second channel (10) disposed in the housing (2) past the at least one capacitor (3) such that the first part air flow (7) is thermally separated from the at least one capacitor (3).

3. Converter arrangement according to claim 1 or 2 with
- a second power electronics module (11), which is disposed in the direction of the cooling air flow (5) beyond the at least one capacitor (3) and
- means for merging (12) the two part air flows (7, 8), with the two merged part air flows (7, 8) being provided for cooling the second power electronics module (11).

4. Converter arrangement according to one of the preceding claims, wherein the converter arrangement is a DC voltage intermediate circuit converter (13).

5. Converter arrangement according to one of the preceding claims, wherein the first power electronics module (6) is an inverter (14) and the at least one capacitor (3) is a DC voltage intermediate circuit capacitor (15).

6. Converter arrangement according to claim 3, wherein the second power electronics module (11) is a rectifier (16).

7. Converter arrangement according to one of the preceding claims with
- a braking unit (17), comprising a braking chopper (18) and at least one braking resistor (19),
- wherein the at least one braking resistor (19) is cooled by at least one part air flow (7, 8).

8. Converter arrangement according to one of the preceding claims, wherein the first power electronics module (6) comprises semiconductor components and a heat sink (31) provided for cooling said components.

9. Converter arrangement according to claim 8, wherein the heat sink (31) is disposed in relation to the cooling air flow (5) such that the first part air flow (7) flows through it and the second part air flow (8) is routed via the first channel (9) past the heat sink (31), such that the second part air flow (8) is thermally separated from the heat sink (31).

10. Converter arrangement according to one of the preceding claims, wherein the housing (2) comprises at least one housing part (23) which has at least one inflow opening (24) for introducing the second part air flow (8) and an outflow opening (25) for venting the second part air flow (8) and which at least partly surrounds the at least one capacitor (3) while forming a cooling air gap (26) between the at least one capacitor (3) and the housing part (23).

11. Converter arrangement according to claim 10, wherein the at least one capacitor (3), together with a number of capacitors (27), is disposed in rows in the direction of the cooling air flow (5), wherein the housing part (23) in each case at least partly encloses a row such that the second channel (10) is formed between the rows, through which the first part air flow (7) is routed past the capacitors (3, 27).

## Revendications

1. Agencement de convertisseur, comprenant
- un coffret ( 2 ),
- au moins un condensateur ( 3 ) disposé dans le coffret ( 2 ),
- un ventilateur ( 4 ) pour la production d'un courant ( 5 ) d'air de refroidissement et
- un premier module ( 6 ) d'électronique de puissance disposé dans le coffret ( 2 ),
- dans lequel le premier module ( 6 ) d'électronique de puissance est, considéré dans le sens du courant ( 5 ) d'air de refroidissement, disposé entre le au moins un condensateur ( 3 ) et le ventilateur ( 4 ),
- le premier module ( 6 ) d'électronique de puissance est placé par rapport au ventilateur ( 4 ), de manière à être refroidi simplement par un premier sous-courant ( 7 ) d'air et
- dans lequel un deuxième sous-courant ( 8 ) d'air, prévu pour le refroidissement du au moins un condensateur ( 3 ), passe dans un premier canal ( 9 ) disposé dans le coffret ( 2 ) sur le premier module ( 6 ) d'électronique de puissance, de manière à ce que le deuxième sous-courant ( 8 ) d'air soit séparé thermiquement du premier module ( 6 ) d'électronique de puissance.

2. Agencement de convertisseur suivant la revendication 1, dans lequel le premier sous-courant ( 7 ) d'air, prévu pour le refroidissement du premier module ( 6 ) d'électronique de puissance, passe dans un deuxième canal ( 10 ) disposé dans le coffret ( 2 ) sur le au moins un condensateur ( 3 ), de manière à ce que le premier sous-courant ( 7 ) d'air soit séparé thermiquement du au moins un condensateur ( 3 ).

3. Agencement de convertisseur suivant la revendication 1 ou 2, comprenant
- un deuxième module ( 11 ) d'électronique de puissance, qui est disposé dans le sens du courant ( 5 ) d'air de refroidissement derrière le au moins un condensateur ( 3 ) et
- des moyens de réunion des deux sous-courants ( 7, 8 ) d'air, les deux sous-courants ( 7, 8 ) d'air réunis étant prévus pour le refroidissement du deuxième module ( 11 ) d'électronique de puissance.

4. Agencement de convertisseur suivant l'une des revendications précédentes, dans lequel l'agencement de convertisseur est un convertisseur ( 3 ) de circuit intermédiaire de tension.

5. Agencement de convertisseur suivant l'une des revendications précédentes, dans lequel le premier module ( 6 ) d'électronique de puissance est un onduleur ( 14 ) et le au moins un condensateur ( 3 ) est un condensateur ( 15 ) de circuit intermédiaire de tension.

6. Agencement de convertisseur suivant la revendication 3, dans lequel le deuxième module ( 11 ) d'électronique de puissance est un redresseur ( 16 ).

7. Agencement de convertisseur suivant l'une des revendications précédentes, comprenant
- une unité ( 17 ) de frein, qui comprend un chopper ( 18 ) de frein et au moins une résistance ( 19 ) de frein,
- dans lequel la au moins une résistance ( 19 ) de frein est refroidie par au moins un sous-courant ( 7, 8 ) d'air.

8. Agencement de convertisseur suivant l'une des revendications précédentes, dans lequel le premier module ( 6 ) d'électronique de puissance comprend des composants à semiconducteurs et un dissipateur ( 31 ) de chaleur prévu pour leur refroidissement.

9. Agencement de convertisseur suivant la revendication 8, dans lequel le dissipateur ( 31 ) de chaleur est disposé, par rapport au courant ( 5 ) d'air de refroidissement, de manière à être parcouru par le premier sous-courant ( 7 ) d'air, et le deuxième sous-courant ( 8 ) d'air passe dans le premier canal ( 9 ) sur le dissipateur ( 31 ) de chaleur, de manière à ce que le deuxième sous-courant ( 8 ) d'air soit séparé thermiquement du dissipateur ( 31 ) de chaleur.

10. Agencement de convertisseur suivant l'une des revendications précédentes, dans lequel le coffret ( 2 ) comprend au moins une partie ( 23 ) de coffret, qui a au moins une ouverture ( 24 ) d'entrée pour l'entrée du deuxième sous-courant ( 8 ) d'air et une ouverture ( 25 ) de sortie pour la sortie du deuxième sous-courant ( 8 ) d'air et qui enferme, au moins en partie, le au moins un condensateur ( 3 ) en formant un intervalle ( 26 ) d'air de refroidissement entre le au moins un condensateur ( 3 ) et la partie ( 23 ) du coffret.

11. Agencement de convertisseur suivant la revendication 10, dans lequel le au moins un condensateur ( 3 ) est disposé ensemble avec plusieurs condensateurs ( 27 ) en des lignes dans le sens du courant ( 5 ) d'air de refroidissement, la partie ( 23 ) du coffret entoure respectivement une ligne, au moins en partie, de manière à former entre les lignes le deuxième canal ( 10 ), dans lequel le premier sous-courant ( 7 ) d'air passe sur les condensateurs ( 3, 27 ).
